# EUROPEAN PATENT APPLICATION

(11) **EP 4 755 704 A1**
(43) Date of publication of application: **10.06.2026**
(21) Application number: 24849610.1
(22) Date of filing: 31.07.2024
(51) Int. Cl.: B60L 53/60, G01R 31/52, G01R 31/66, G01R 31/56, G01R 19/165

(54) **CHARGING DEVICE FOR ELECTRIC VEHICLE**

(30) Priority: 02.08.2023 KR 20230101220
(71) Applicant: LG INNOTEK CO. LTD, Gangseo-gu Seoul 07796 (KR)
(72) Inventor: SHIN, Kwang Seob, Seoul 07796 (KR)
(74) Representative: DREISS Patentanwälte PartG mbB
(86) International application number: PCT/KR2024/011240
(87) International publication number: WO 2025/029043

(57) **Abstract**

A charging apparatus for an electric vehicle according to an embodiment of the present invention includes a charging control unit configured to generate a charging control signal, a connection unit connected to electric vehicle supply equipment (EVSE) to deliver power received from the EVSE based on the charging control signal, and a detection unit, wherein the connection unit includes a first pin configured to receive a first charging sequence signal from the EVSE, a second pin configured to receive a second charging sequence signal from the EVSE, a third pin configured to receive a connector proximity detection signal from the EVSE, a fourth pin configured to transmit a charge permission signal to the EVSE, and a rapid charging terminal, and the detection unit is configured to detect a short circuit or open circuit between the EVSE and the fourth pin.

## Description

### [Technical Field]

The present invention relates to electric vehicles, and more particularly, to the charging of electric vehicles.

### [Background Art]

Eco-friendly vehicles, such as Electric Vehicles (EVs) or Plug-In Hybrid Electric Vehicles (PHEVs), rely on electric vehicle supply equipment (EVSE) installed at charging stations to replenish their battery power.

To charge an electric vehicle, the EV and EVSE communicate through a charging connector that connects the EV to the EVSE. Once the charging connector is connected between the EVSE and the EV, a signaling process ensues to initiate the charging operation.

During this signaling process, there is a need to detect short circuits or open circuits between the connection pins of the EVSE and the EV.

### [Detailed Description of Invention]

### [Technical Problem]

The present invention aims to provide a charging apparatus for charging an electric vehicle.

### [Technical Solution]

A charging apparatus for an electric vehicle according to an embodiment of the present invention includes a charging control unit configured to generate a charging control signal, a connection unit connected to electric vehicle supply equipment (EVSE) to deliver power received from the EVSE based on the charging control signal, and a detection unit, wherein the connection unit includes a first pin configured to receive a first charging sequence signal from the EVSE, a second pin configured to receive a second charging sequence signal from the EVSE, a third pin configured to receive a connector proximity detection signal from the EVSE, a fourth pin configured to transmit a charge permission signal to the EVSE, and a rapid charging terminal, and the detection unit is configured to detect a short circuit or open circuit between the EVSE and the fourth pin.

The detection unit may detect at least one of an open circuit between the EVSE and the fourth pin, a ground short circuit between the EVSE and the fourth pin, or a battery short circuit between the EVSE and the fourth pin.

The open circuit and ground short circuit between the EVSE and the fourth pin may be detected based on the EVSE and the connection unit being connected, and the battery short circuit between the EVSE and the fourth pin may be detected based on the EVSE and the connection unit being not connected.

The open circuit or ground circuit between the EVSE and the fourth pin may be indicated by the detection unit reading 0V in the connected state between the EVSE and the connection unit, and the battery short circuit between the EVSE and the fourth pin may be indicated by the detection unit reading a voltage exceeding 0V in the disconnected state between the EVSE and the connection unit.

The fourth pin may further include a transistor connected to the EVSE and a resister disposed between the transistor and the ground, and the detection unit is connected to a node between the transistor and the resistor.

The detection unit may detect the voltage across both ends of the resistor.

The detection unit may include an amplifier.

The fourth pin may further include a filter disposed between the EVSE and the transistor.

The resistor may have a resistance equal to or less than 3.5kΩ.

The transistor may have a maximum voltage of 0.5V across both terminals thereof.

A charging system for an electric vehicle (EV) according to an embodiment of the present invention includes a first charging apparatus installed in the EV, and a second charging apparatus installed in electric vehicle supply equipment (EVSE), wherein the first charging apparatus includes a first pin configured to receive a first charging sequence signal from the EVSE, a second pin configured to receive a second charging sequence signal from the EVSE, a third pin configured to receive a connector proximity detection signal from the EVSE, a fourth pin configured to transmit a charge permission signal to the EVSE, a detection unit configured to detect a short circuit or open circuit between the EVSE and the fourth pin, and a first rapid charging terminal configured to receive power from the EVSE, the second charging apparatus includes a fifth pin configured to transmit the first charging sequence signal to the EV, a sixth pin configured to transmit the second charging sequence signal to the EV, a seventh pin configured to transmit the connector proximity detection signal to the EV, an eighth pin configured to receive the charge permission signal from the EVSE, and a second rapid charging terminal configured to transmit power to the EV, the first, second, third, and fourth pins, and the first rapid terminal of the first charging apparatus corresponding to the fifth, sixth, seventh, and eighth pins, and the second rapid charging terminal of the second charging apparatus.

The eighth pin may include an optocoupler.

### [Advantageous Effects]

According to an embodiment of the present invention, it is advantageous to be able to detect short circuits or open circuits between the connection pins of the EVSE and the EV during the signaling process. Particularly, according to an embodiment of the present invention, it is advantageous to be able to detect open circuits, ground short circuits, or battery short circuits between the pins transmitting the charging permission signal of the EVSE and the EV.

### [Description of Drawings]

FIGS. 1 to 3 are diagrams illustrating a charging system for an electric vehicle according to an embodiment of the present invention;
FIG. 4 is a diagram illustrating the pinout of a connector included in a charging device according to an embodiment of the present invention;
FIG. 5 is a circuit diagram illustrating a charging interface between EVSE and EV according to an embodiment of the present invention;
FIG. 6 is a circuit diagram illustrating a charging interface between EVSE and EV according to another embodiment of the present invention;
FIG. 7 is a circuit diagram illustrating the interface between EVSE and DCP pin among the charging interfaces between EVSE and EV according to an embodiment of the present invention; and
FIG. 8 is a circuit diagram for simulating detectability of faults by type between EVSE and DCP pins.

### [Modes of the Invention]

Hereinafter, preferred embodiments of the present invention are described in detail with reference to the accompanying drawings.

However, the technical concept of the present invention is not limited to the embodiments described herein but can be implemented in various other forms, allowing for selective combination or substitution of one or more components among different embodiments within the scope of the technical concept of the present invention.

Unless explicitly defined otherwise, terms used in the embodiments of the present invention (including technical and scientific terms) should be interpreted in meanings understood by those skilled in the art to which the present invention pertains considering the context of the technology involved, rather than solely based on their usual or dictionary meanings.

Furthermore, the terminology employed in the embodiments of the present invention is intended solely for the purpose of elucidating the embodiments and should not be construed as limiting the scope of the present invention.

In this specification, singular language may include the plural unless specifically mentioned otherwise, and when stated as "at least one (or one or more) of A, B, and (or) C," it may include one or more of all possible combinations of A, B, and C.

Additionally, when describing the components of the embodiments of the present invention, terms such as "first," "second," "A," "B," "(a)," and "(b)" may be used.

These terms are intended solely for the purpose of distinguishing one component from another and do not limit the essence, order, or sequence of respective components.

Furthermore, when a component is described as being "connected," "coupled," or "attached" to another component, it may include not only direct connection, coupling, or attachment but also connection, coupling, or attachment through another component located between the component and the other component.

Additionally, when a component is described as being formed or placed "on or under" another component, "on (above)" or "under (below)" may include not only cases where two components directly contact each other but also cases where one or more other components are formed or positioned between the two components. Additionally, when expressed as "on (above or under (below)," it may include not only the upward direction but also the downward direction relative to a single component.

Hereinafter, a description is made of the charging system for a vehicle with reference to the accompanying drawings where identical or corresponding components are assigned the same reference numbers, and redundant descriptions are omitted.

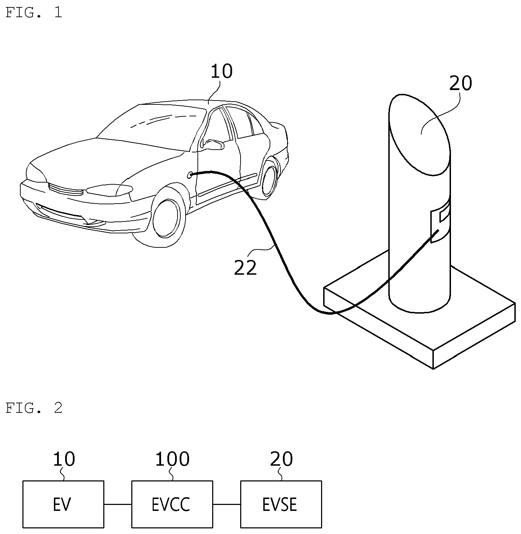

FIGS. 1 to 3 are diagrams illustrating a charging system for an electric vehicle according to an embodiment of the present invention.

With reference to FIGS. 1 to 3, an electric vehicle (EV) 10 may be charged from electric vehicle supply equipment (EVSE) 20. To achieve this, the charging cable 22 connected to the EVSE 20 may be connected to the charging port of the EV 10. Here, EVSE 20 is a facility that supplies AC or DC power, which may be installed at charging stations, within homes, or designed to be portable. EVSE 20 may be interchangeably referred to as a charging station, AC charger, DC charger, or socket-outlet.

The charging apparatus (electric vehicle charging controller (EVCC)) 100 is installed within the EV 10 and is connected to the EV 10. For example, the charging apparatus 100 may be installed inside the trunk of the EV 10, but this is not limiting.

Here, the charging apparatus 100 may communicate with both the EV 10 and the EVSE 20.

According to an embodiment of the present invention, the charging apparatus 100 includes a charging control unit 110, a connection unit 120, and a detection unit 130.

The charging control unit 110 generates control signals for charging between the EV 10 and EVSE 20. The control signals for charging generated by the charging control unit 110 may be transmitted to the EVSE 20 via the connection unit 120 or to the electric control unit (ECU) 12 within the EV 10.

The connection unit 120 is connected to the EVSE 20 and transmits signals between the charging control unit 110 and the EVSE 20. For example, the connection unit 120 may relay charging-related signals received from the EVSE 20 to the charging control unit 110 and may transmit control signals for charging generated by the charging control unit 110 to the EVSE 20. The connection unit 120 may also deliver power received from the EVSE 20 to the battery 14 inside the EV 10 according to the charging control signals generated by the charging control unit 110.

The detection unit 130 detects diagnostic trouble codes (DTCs) between the EV 10 and EVSE 20. The detection unit 130 is connected to both the connection unit 120 and the charging control unit 110 to relay detected DTCs from the connection unit 120 to the charging control unit 110.

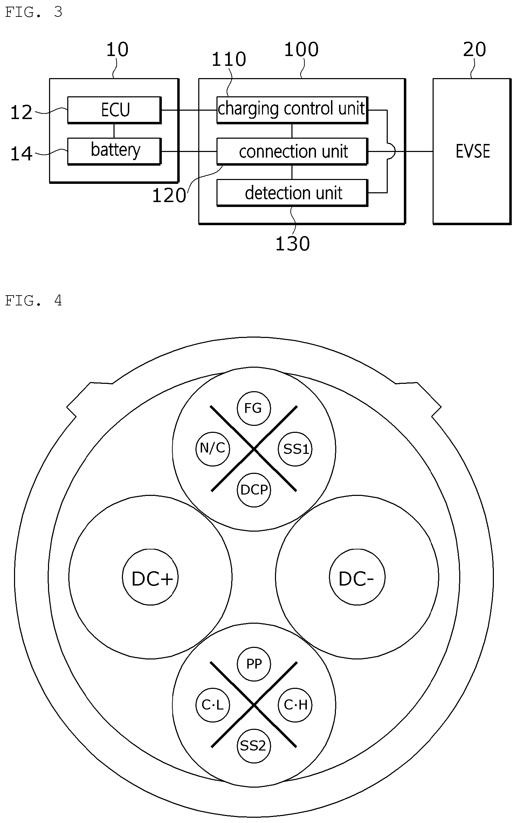

FIG. 4 is a diagram illustrating the pinout of a connector included in a charging device according to an embodiment of the present invention. The pinout illustrated in FIG. 4 may represent the configuration seen at the end of the EV-side connector.

With reference to FIG. 4, the connection unit 120 may include a total of 10 pins. For example, the connection unit 120 may include FG pin, SS1 pin, SS2 pin, N/C pin, DCP pin, DC+ pin, DC- pin, PP pin, C-H pin, and C-L pin.

Here, the FG pin is a ground pin that may serve as a reference for the control line.

The SS1 pin and SS2 pin are pins for receiving charging sequence signals from the EVSE 20, providing load current to the relay on the EV 10 side. The SS1 and SS2 pins may be referred to as charge start and stop 1 pin and charge start and stop 2 pin, respectively, or as charge sequence signal 1 pin and charge sequence signal 2 pin.

The N/C pin may be a not connected pin.

The DCP pin is a pin for transmitting a charge permission signal to the EVSE 20 and may be referred to as the charge permission and prohibition pin or the vehicle charge permission pin.

The DC- pin and DC+ pin are rapid charging terminals for receiving power from the EVSE 20.

The PP pin is a pin for receiving the connector proximity detection signal from the EVSE 20 and may be referred to as the verification of connector connection pin or the connector proximity detection pin. The PP pin may be used to verify the connection of the charging cable.

The C-H pin and C-L pin may be control area network (CAN) bus pins that communicate with the EV bus to set operating parameters. Once the PP pin verifies the connection of the charging cable, battery information from the EV 10 is transmitted to the EVSE 20 through the C-H and C-L pins, information from the EVSE 20 is transmitted to the EV 10, and a compatibility check between the EV 10 and EVSE 20 may be performed.

Meanwhile, the end of the connector on the EVSE 20 side may have a shape corresponding to the end of the connector on the EV 10 side.

That is, the end of the connector on the EVSE 20 side may include a pin that transmits the first charging sequence signal to the EV 10, corresponding to the SS1 pin in FIG. 4, a pin that transmits the second charging sequence signal to the EV 10, corresponding to the SS2 pin in FIG. 4, a pin that transmits the connector proximity detection signal to the EV 10, corresponding to the PP pin in FIG. 4, a pin that receives the charge permission signal from the EV 10, corresponding to the DCP pin in FIG. 4, and rapid charging terminals that transmit power to the EV 10, corresponding to the DC- and DC+ pins in FIG. 4.

Additionally, the end of the connector on the EVSE 20 side may further include a pin corresponding to at least one of the FG pin, N/C pin, C-H pin, and C-L pin in FIG. 4.

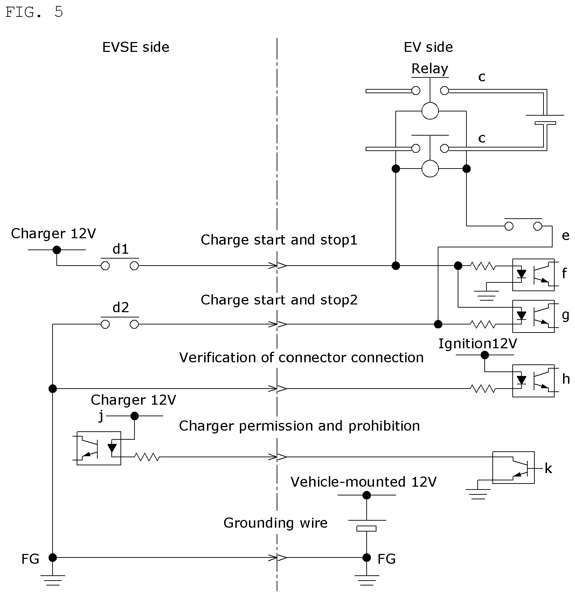

FIG. 5 is a circuit diagram illustrating a charging interface between EVSE and EV according to an embodiment of the present invention. The charging interface between the EVSE and the EV may be a circuit diagram showing the connected state of the end of the connector on the EV 10 side and the end of the connector on the EVSE 20 side.

With reference to FIG. 5, when switch d1 is pressed on the EVSE 20 side, the first charging sequence signal is transmitted from the EVSE 20 to the EV 10 through the SS1 pin, or charging start and stop 1 pin, causing current to flow through the optocoupler f on the EV 10 side.

Similarly, when switch d2 is pressed on the EVSE 20 side, the second charging sequence signal is transmitted from the EVSE 20 to the EV 10 through the SS2 pin, or charging start and stop 2 pin, causing current to flow through the optocoupler g on the EV 10 side.

When the connector proximity detection signal from the EVSE 20 is transmitted to the EV 10 through the PP pin, or verification of connector connection pin, current flows through optocoupler h, allowing the EV 10 to detect whether the connector is properly engaged.

Once charging is prepared on the EV 10 side and transistor k is activated, grounding occurs, forming a current path and sending a charge permission signal to the EVSE 20 through the DCP pin, or charge permission and prohibition pin, causing current to flow through optocoupler j on the EVSE 20 side.

After the transmission of the first charging sequence signal from the EVSE 20 to the EV 10, the second charging sequence signal from the EVSE 20 to the EV 10, the connector proximity detection signal from the EVSE 20 to the EV 10, and the charge permission signal from the EV 10 to the EVSE 20, the battery relay on the EV 10 side is turned on, and charging may commence.

The sequence of transmitting the first charging sequence signal from the EVSE 20 to the EV 10, the second charging sequence signal from the EVSE 20 to the EV 10, the connector proximity detection signal from the EVSE 20 to the EV 10, and the charge permission signal from the EV 10 to the EVSE 20 is not limited to this order. For example, the sequence may proceed in the order of transmission of the first charging sequence signal from the EVSE 20 to the EV 10, transmission of the connector proximity detection signal from the EVSE 20 to the EV 10, transmission of the charge permission signal from the EV 10 to the EVSE 20, and transmission of the second charging sequence signal from the EVSE 20 to the EV 10.

The component-specific requirements in the circuit diagram shown in FIG. 5 are as follows in Table 1.

**[Table 1]**

| Component | Requirements |
|---|---|
| Charge start and stop 1, 2 | Rated 2A |
| Optocoupler f, g | 2mA |
| Optocoupler h | ~50mA |
| Optocoupler j | ~50mA |

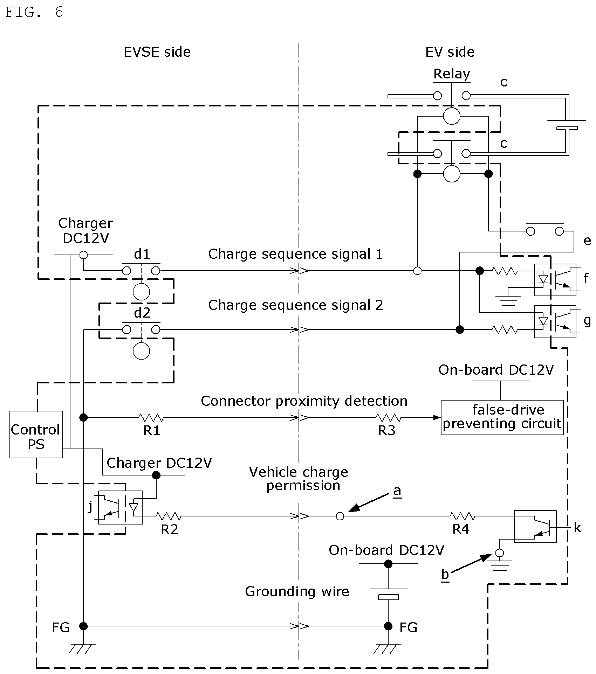

FIG. 6 is a circuit diagram illustrating a charging interface between EVSE and EV according to another embodiment of the present invention. The charging interface between the EVSE and the EV may be a circuit diagram showing the connected state of the end of the connector on the EV 10 side and the end of the connector on the EVSE 20 side.

With reference to FIG. 6, when switch d1 is pressed on the EVSE 20 side, the first charging sequence signal is transmitted from the EVSE 20 to the EV 10 through the SS1 pin, or charge sequence signal 1 pin, causing current to flow through the optocoupler f on the EV 10 side.

Similarly, when switch d2 is pressed on the EVSE 20 side, the second charging sequence signal is transmitted from the EVSE 20 to the EV 10 through the SS2 pin, or charging sequence signal 2 pin, causing current to flow through the optocoupler g on the EV 10 side.

When the connector proximity detection signal from the EVSE 20 is transmitted to the EV 10 through the PP pin, or connector proximity detection pin, the EV 10 may detect whether the connector is properly engaged.

Once charging is prepared on the EV 10 side and transistor k is activated, grounding occurs, forming a current path and sending a charge permission signal to the EVSE 20 through the DCP pin, or vehicle charge permission pin, causing current to flow through optocoupler j on the EVSE 20 side.

After the transmission of the first charging sequence signal from the EVSE 20 to the EV 10, the second charging sequence signal from the EVSE 20 to the EV 10, the connector proximity detection signal from the EVSE 20 to the EV 10, and the charge permission signal from the EV 10 to the EVSE 20, the battery relay on the EV 10 side is turned on, and charging may commence.

The sequence of transmitting the first charging sequence signal from the EVSE 20 to the EV 10, the second charging sequence signal from the EVSE 20 to the EV 10, the connector proximity detection signal from the EVSE 20 to the EV 10, and the charge permission signal from the EV 10 to the EVSE 20 is not limited to this order. For example, the sequence may proceed in the order of transmission of the first charging sequence signal from the EVSE 20 to the EV 10, transmission of the connector proximity detection signal from the EVSE 20 to the EV 10, transmission of the charge permission signal from the EV 10 to the EVSE 20, and transmission of the second charging sequence signal from the EVSE 20 to the EV 10.

The component-specific requirements for the EVSE side in the circuit diagram shown in FIG. 6 are as follows in Table 2.

**[Table 2]**

| Terminal | Item | Minimum value | Typical value | Maximum value | Unit |
|---|---|---|---|---|---|
| Charge sequence signal 1 | Charger DC12V | 10.8 | 12.0 | 13.2 | V |
| Connector proximity detection | Resistor R1 | 190 | 200 | 210 | Ω |
| Vehicle charge permission | Resistor R2 | 950 | 1000 | 1050 | Ω |
| Charge sequence signal 1 | Relay d1 load current | 2 | | 2000 | mA |
| Charge sequence signal 2 | Relay d2 load current | 2 | | 2000 | mA |

The component-specific requirements for the EV side in the circuit diagram shown in FIG. 6 are as follows in Table 3.

**[Table 3]**

| Terminal | Item | Minimum value | Typical value | Maximum value | Unit |
|---|---|---|---|---|---|
| Charge sequence signal 1 | Load current (when d1 ON) | 10 | | 2000 | mA |
| Charge sequence signal 2 | Load current (when d1 an d2 ON) | 10 | | 2000 | mA |
| Connector proximity detection | Resistor R3 | 950 | 1000 | 1050 | Ω |
| | On-board DC 12V | 8 | 12 | 16 | V |
| Vehicle charge permission | Resistor R4 | 190 | 200 | 210 | Ω |
| Vehicle charge permission | Load current (leakage current) between a-b when switch k OFF | | | 2 | mA |
| | Vce (collector-emitter voltage of transistor "k") at collector current=10mA | | | 0.5 | V |

Meanwhile, according to an embodiment of the present invention, the detection unit 130 detects diagnostic trouble codes (DTCs) between the EV 10 and the EVSE 20. In particular, during the charging sequence between EVSE 20 and EV 10, there is a need to detect whether the connection status is normal between EVSE 20 and EV 10 when the charge permission signal is transmitted from EV 10 to EVSE 20, i.e., to detect any short circuits or open circuits between the DCP pins of the EVSE 20 and the EV10.

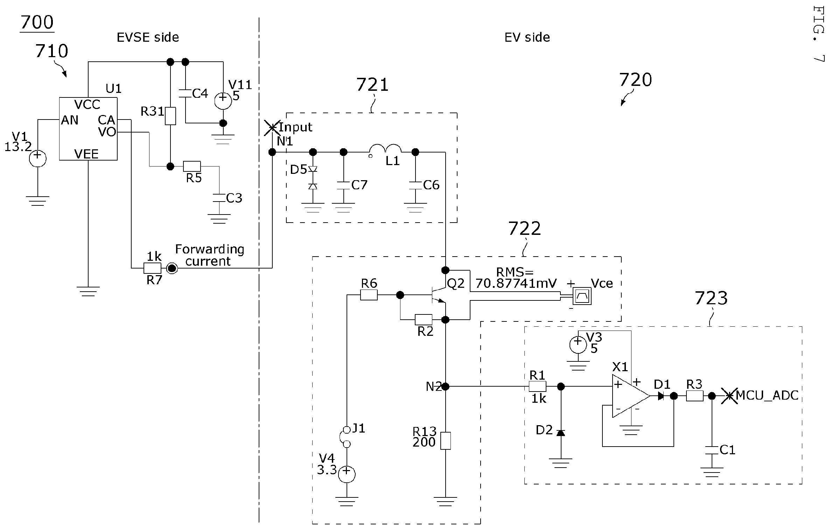

FIG. 7 is a circuit diagram illustrating the interface between EVSE and DCP pins among the charging interfaces between EVSE and EV according to an embodiment of the present invention.

With reference to FIG. 7, the circuit diagram 700 of the interface between the EVSE and the DCP pins includes the EVSE side circuit diagram 710 and the EV side circuit diagram 720, which may be connected at connection node N1. The connection node N1 may denote the junction between the terminals of the DCP pins of the EVSE 20 side connector and the EV 10 side connector.

The EV side circuit diagram 720 includes a filter section 721, a switch section 722 connected to the filter section 721, and a detection section 723 connected to the switch section 722.

According to an embodiment of the present invention, when charging is ready at the EV 10 side and the switch section 722 is turned on, creating a ground path allows current to flow, transmitting the charge permission signal to the EVSE 20, thereby allowing current to flow through the optocoupler U1 on the EVSE 20 side.

According to an embodiment of the present invention, the filter section 721 may be positioned between the connection node N1, which connects the EVSE circuit diagram 710 and EV circuit diagram 720, and the switch section 722. The filter section 721 may include at least one of an electrostatic discharge (ESD) filter, a surge filter, an electromagnetic compatibility (EMC) filter, or an electromagnetic interference (EMI) filter.

According to an embodiment of the present invention, the switch section 722 is positioned between the filter section 721 and ground, and includes transistor k and resistor R13. Here, transistor k may correspond to transistor k in FIG. 5 and transistor k in FIG. 6. According to an embodiment of the present invention, the connection node N1, filter section 721, transistor k, resistor R13, and ground may be arranged sequentially as shown in the drawing. For example, the connection node N1, filter section 721, transistor k, resistor R13, and ground may be serially connected. In this configuration, the voltage Vce across the terminals of transistor k is set to 0.5V or less, and resistor R13 is set to 3.5kΩ or less, preferably within the range of 190Ω to 210Ω, for instance, 200Ω. Accordingly, when charging is ready at the EV10 side and transistor k is activated, grounding occurs, forming a current path and sending the charge permission signal to EVSE 20, thereby allowing current to flow through optocoupler U1 on the EVSE 20 side.

Table 4 presents simulated voltage values read by the EV MCU based on EVSE-side voltage V1 and resistance R7 in the circuit diagram of FIG. 7.

**[Table 4]**

| EVSE side voltage V1 | 10.8V | | 13.2V | |
|---|---|---|---|---|
| EVSE side resistance R7 | EVSE side Forward current (mA) | Voltage value (V) read by EV-side MCU | EVSE side Forward current (mA ) | Voltage value (V) read by EV-side MCU |
| 0 | 10.6 | 2.2 | 10.7 | 2.2 |
| 1 kΩ | 7.6 | 1.64 | 9.6 | 2 |
| 3.5kΩ | 2.4 | 0.7 | 3.1 | 0.82 |
| 5 kΩ | 1.7 | 0.57 | 2.2 | 0.65 |
| 10kΩ | 0.8 | 0.41 | 1.1 | 0.45 |
| 15kΩ | 0.6 | 0.36 | 0.7 | 0.39 |
| 20kΩ | 0.4 | 0.33 | 0.5 | 0.35 |

With reference to FIG. 4, when the EVSE 20 side voltage V1 is 10.8V and the EVSE 20 side resistance R7 is set between 0 and 20kΩ, the voltage read by the EV 10 MCU ranges from 0.33V to 2.2V, resulting in EVSE 20 side forward current ranging from 0.4mA to 10.6mA, satisfying the requirement in Table 1 that the current flowing through Optocoupler j is 50mA or less. Similarly, when the EVSE 20 side voltage V1 is 13.2V and the EVSE 20 side resistance R7 is set between 0 and 20kΩ, the voltage read by the EV 10 MCU ranges from 0.35V to 2.2V, resulting in an EVSE 20 side forward current of 0.35mA to 10.7mA, satisfying the requirement in Table 1 that the current flowing through Optocoupler j is 50mA or less.

With reference to FIG. 4, in both cases where EVSE 20 side voltage V1 is 10.8V and where EVSE 20 side voltage V1 is 13.2V, when EVSE 20 side resistance R7 is set to 1kΩ, the voltage is read by the EV 10 MCU, satisfying the requirements of Tables 2 and 3.

As such, the circuit diagram according to an embodiment of the present invention demonstrates that EVSE 20 and EV 10 satisfy the requirements of Tables 1 to 3 under normal connection conditions.

Meanwhile, according to an embodiment of the present invention, the circuit diagram of the interface between EVSE 20 and the DCP pin among the charging interfaces between the EVSE 20 and the EV 10 may further include the detection section 723 for detecting a diagnostic trouble code (DTC) between the EVSE 20 and the DCP pin. The DTC between EVSE 20 and the DCP pin may be an open circuit or a short circuit between EVSE 20 and the DCP pin. According to an embodiment of the present invention, the detection section 723 may detect at least one of an open circuit between EVSE and the DCP pin, a ground fault between EVSE and the DCP pin, or a battery fault between EVSE and the DCP pin. The detection section 723 may be configured as part of the detection unit 130 in FIG. 3.

To achieve this, the resistor R13 of the switch section 722 may be placed between the transistor k and ground, and the detection section 723 may be connected to node N2 between the transistor k and resistor R13. With the configuration, the detection section 723 may detect the voltage across the terminals of resistor R13.

According to an embodiment of the present invention, the detection section 723 may include an amplifier X1. Consequently, signals entering the input node N2 of the detection section 723 may be amplified by the amplifier X1, thereby enhancing the detection accuracy.

According to an embodiment of the present invention, when 0V is detected by the detection section 723 while EVSE 20 and EV 10 are connected by a charging cable, this may indicate an open circuit between EVSE and the DCP pin or a ground fault between EVSE and the DCP pin. Here, 0V may refer to a voltage within the error range, not exactly 0V. For example, when the expected voltage under normal conditions is 2.2V, detecting a voltage within 20% of the expected voltage, preferably within 10%, may indicate an open circuit or ground fault between EVSE and the DCP pin. When a voltage greater than 0V is detected by the detection section 723 while EVSE and EV are not connected by a charging cable, this may indicate a battery short circuit between EVSE and the DCP pin. Accordingly, the EV side charging apparatus according to an embodiment of the present invention can detect DTC between EVSE and the DCP pin.

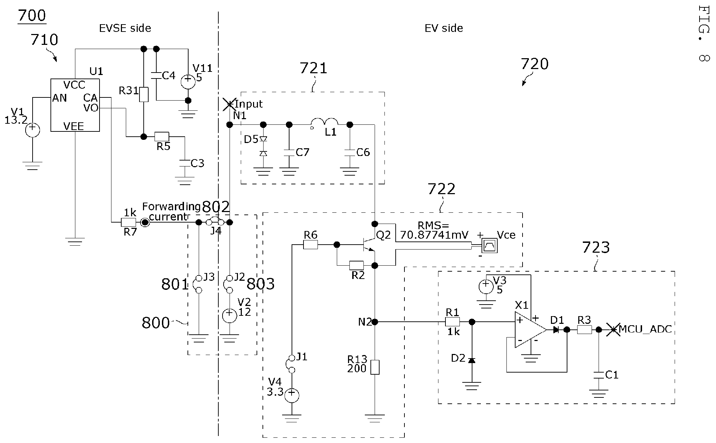

FIG. 8 is a circuit diagram for simulating detectability of faults by type between EVSE and DCP pins.

With reference to FIG. 8, a fault type section 800 is further arranged between the EVSE side circuit diagram 710 and the EV side circuit diagram 720, which is an interface through which a charging permission signal is transmitted from the EV 10 to the EVSE 20.

The fault type section 800 includes a first switch 801, a second switch 802, and a third switch 803.

A closed state of the first switch 801 may indicate a ground short circuit (short to ground) among the fault types between the EVSE 20 and the DCP pin, an open state of the second switch 802 may indicate an open circuit (open) among the fault types between the EVSE 20 and the DCP pin, and a closed state of the third switch 803 may indicate a battery short circuit (short to battery) among the fault types between the EVSE 20 and the DCP pin.

Table 5 shows the voltages read by the detection section for each fault type when the EVSE 20 and EV 10 are connected and not connected via a charging cable.

**[Table 5]**

| Fault Type | Connection between EVSE and EV | | | | Disconnection between EVSE and EV | | | |
|---|---|---|---|---|---|---|---|---|
| | Expected voltage on external pin | Expected voltage on EV side | Voltage on EV side | Detecta bility | Expected voltage on external pin | Expected voltage on EV side | Voltage on EV side | Detecta bility |
| Ground short circuit | 0V | 2.2V | 0V | Detecta ble | 0V | 0V | 0V | Undetec table |
| Open circuit | 0V | 2.2V | 0.0V | Detectable | 0V | 0V | 0V | Undetectable |
| Battery short circuit | 12V | 2.2V | 2.2V | Undetectable | 12V | 0V | 2.2V | Detectable |

With reference to FIG. 8 and Table 5, when the EVSE 20 side voltage is 10.8V and the EVSE 20 side resistance R7 is set to 0Ω, the EVSE 20 and EV 10 are connected via a charging cable, and the connection between EVSE 20 and the DCP pin is in normal condition, then a voltage of 2.2V is expected to be read by the EV side detection section 723.

When the first switch 801 is closed, the second switch 802 is closed, and the third switch 803 is open in the fault type section 800 of FIG. 8, resulting in a short-to-ground condition, then the EV 10 side detection section 723 will read a voltage of 0V. As such, when the EV 10 side detection section 723 reads 0V instead of the expected 2.2V in the state where the EVSE 20 and EV 10 are connected via a charging cable, this may indicate a ground short circuit (short-to-ground) condition between the EVSE 20 and the DCP pin.

Next, when the second switch 802 in the fault type section 800 of FIG. 8 is open, resulting in an open circuit condition, then the EV 10 side detection section 723 will read a voltage of 0V. As such, when the EV 10 side detection section 723 reads lower than 2.2V and closer to 0V instead of the expected 2.2V in the state where the EVSE 20 and EV 10 are connected via a charging cable, this may indicate an open circuit (open) condition between the EVSE 20 and the DCP pin.

However, when the first switch 801 is open, the second switch 802 is closed, and the third switch 803 is closed in the fault type section 800 of FIG. 8, resulting in a battery short circuit (short to battery) condition, the EV 10 side detection section 723 will still read a voltage of 2.2V. This is because the voltage reading from the EV 10 side detection section 723 is the same for both normal operation and a battery short circuit between the EVSE 20 and the DCP pin when the EVSE 20 and EV 10 are connected via a charging cable, making it difficult to detect a battery short circuit between the EVSE 20 and the DCP pin.

Meanwhile, when the EVSE 20 side voltage is 10.8V and the EVSE 20 side resistance R7 is set to 0Q, and the EVSE 20 and EV 10 are not connected via a charging cable, it is expected that a voltage of 0V will be read by the EV 10 side detection section 723.

However, when the first switch 801 is closed, the second switch 802 is closed, and the third switch 803 is open in the fault type section 800 of FIG. 8, resulting in a ground short circuit (short to ground) condition, the EV side detection section 723 will read a voltage of 0V. This is because the expected voltage reading from the EV 10 side detection section 723 when the EVSE 20 and EV 10 are not connected via a charging cable is the same as the voltage reading for a ground short circuit (short to ground) condition, making it difficult to detect a ground short circuit.

Next, when the second switch 802 in the fault type section 800 of FIG. 8 is open, resulting in an open circuit condition, then the EV 10 side detection section 723 will read a voltage of 0V. This is because the expected voltage reading from the EV 10 side detection section 723 when the EVSE 20 and EV 10 are not connected via a charging cable is the same as the voltage reading for a ground short circuit (short to ground) condition, making it difficult to detect a ground short circuit.

However, when the first switch 801 is open, the second switch 802 is closed, and the third switch 803 is closed in the fault type section 800 of FIG. 8, resulting in a battery short circuit (short to battery) condition, the EV 10 side detection section 723 will read a voltage of 2.2V. As such, when the EV 10 side detection section 723 reads a voltage of 2.2V instead of the expected 0V in the state where the EVSE 20 and EV 10 are not connected via a charging cable, this may indicate a battery short circuit (short to battery) condition.

As described above, according to an embodiment of the present invention, the voltage read by the detection section 723 can be used to detect a DTC. When the voltage read by detection section 723 differs from the expected voltage in either the connected or disconnected state of EVSE 20 and EV 10 via the charging cable, it can trigger the detection of a DTC. For example, the voltage readings obtained by the detection section 723 when EVSE 20 and EV 10 are connected via a charging cable can be used to detect ground short circuit (short to ground) and open circuit (open), while the voltage readings obtained by the detection section 723 when EVSE 20 and EV 10 are not connected via a charging cable can be used to detect battery short circuit (short to battery).

Although the preferred embodiments of this invention have been described above, it will be understood by those skilled in the art that this invention can be variously modified and changed without departing from the spirit and scope of this invention as set forth in the following patent claims.

### [DESCRIPTION OF REFERENCE NUMERALS]

- 10:: EV
- 20:: EVSE
- 22:: charging cable
- 100:: charging apparatus
- 110:: charging control unit
- 120:: connection unit
- 130:: detection unit
- 710:: EVSE side circuit diagram
- 720:: EV side circuit diagram
- 721:: filter section
- 722:: switch section
- 723:: detection unit
- 800:: fault type section

## Claims

1. A charging apparatus for an electric vehicle, the apparatus comprising:
a charging control unit configured to generate a charging control signal;
a connection unit connected to electric vehicle supply equipment (EVSE) to deliver power received from the EVSE based on the charging control signal; and
a detection unit,
wherein the connection unit comprises a first pin configured to receive a first charging sequence signal from the EVSE, a second pin configured to receive a second charging sequence signal from the EVSE, a third pin configured to receive a connector proximity detection signal from the EVSE, a fourth pin configured to transmit a charge permission signal to the EVSE, and a rapid charging terminal configured to receive power from the EVSE, and
wherein the detection unit is configured to detect a short circuit or open circuit between the EVSE and the fourth pin.

2. The apparatus of claim 1, wherein the detection unit detects at least one of an open circuit between the EVSE and the fourth pin, a ground short circuit between the EVSE and the fourth pin, or a battery short circuit between the EVSE and the fourth pin.

3. The apparatus of claim 1, wherein the open circuit and ground short circuit between the EVSE and the fourth pin are detected based on the EVSE and the connection unit being connected, and the battery short circuit between the EVSE and the fourth pin is detected based on the EVSE and the connection unit being not connected.

4. The apparatus of claim 3, wherein the open circuit or ground circuit between the EVSE and the fourth pin is indicated by the detection unit reading 0V in the connected state between the EVSE and the connection unit, and the battery short circuit between the EVSE and the fourth pin is indicated by the detection unit reading a voltage exceeding 0V in the disconnected state between the EVSE and the connection unit.

5. The apparatus of claim 3, wherein the fourth pin further comprises a transistor connected to the EVSE and a resister disposed between the transistor and the ground, and the detection unit is connected to a node between the transistor and the resistor.

6. The apparatus of claim 5, wherein the detection unit detects the voltage across both ends of the resistor.

7. The apparatus of claim 5, wherein the detection unit comprises an amplifier.

8. The apparatus of claim 5, wherein the fourth pin further comprises a filter disposed between the EVSE and the transistor.

9. The apparatus of claim 5, wherein the resistor has a resistance equal to or less than 3.5kΩ.

10. The apparatus of claim 5, wherein the transistor has a maximum voltage of 0.5V across both terminals thereof.
